(19) Europäisches Patentamt
European Patent Office
Office européen des brevets

(11) **EP 3 584 355 A1**

(12) **EUROPEAN PATENT APPLICATION**

(43) Date of publication:
**25.12.2019 Bulletin 2019/52**

(51) Int Cl.:
*C30B 29/06* (2006.01)    *C30B 35/00* (2006.01)
*B28D 5/00* (2006.01)    *C01B 33/021* (2006.01)

(21) Application number: **18305753.8**

(22) Date of filing: **18.06.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Total SA**
**92400 Courbevoie (FR)**

(72) Inventor: **SACHS, Christoph**
**78530 BUC (FR)**

(74) Representative: **Croonenbroek, Thomas Jakob et al**
**Innovincia**
**11, avenue des Tilleuls**
**74200 Thonon-les-Bains (FR)**

(54) **METHOD FOR RECYCLING SUB-MICRON SI-PARTICLES FROM A SI WAFER PRODUCTION PROCESS AND SILICON WAFER PRODUCTION FACILITY**

(57)    The invention relates to a method for processing a coolant liquid, herein called suspension, retrieved from a cutting step of silicon ingots to produce wafers based on a diamond fixed abrasion process, the said suspension being an aqueous solution comprising kerf particles and additives such as surfactants, lubricants, anti-foaming agents, the additives having a concentration below 5% in volume, the method comprising steps for separating at least partially the silicon particles and the liquid part of the suspension, the said steps comprising:
- an agglomeration step (100-3) wherein the suspension is stored in a container for a predetermined time longer than 10 minutes to enable agglomeration of remaining kerf particles to form clusters of kerf particles (100-3-2),
- a centrifugation step (100-4) to produce a centrifugation cake or high-viscosity suspension comprising the clusters of kerf particles and a centrate comprising the liquid part of the suspension wherein the centrate has a concentration of kerf particles lower than lOg/L, preferably lower than 1g/L.

FIG. 1

EP 3 584 355 A1

## Description

FIELD OF THE INVENTION

The invention relates to a method for recycling sub-micron silicon (Si) particles from a silicon (Si) wafer production process in particular for recycling Si-kerf from diamond fixed abrasion process like diamond wire sawing, more specifically in a way that it can be reused to produce in particular silicon ingots and wafers with sufficient quality for solar cell manufacturing.

BACKGROUND AND PRIOR ART

The semiconductor and photovoltaic industry relies on the manufacturing of high quality silicon wafers at optimized and low cost.

During manufacturing, a silicon single crystal is formed from polycrystalline silicon feedstock by known methods like floating zone melting method (or FZ method in short) or Czochralski method (CZ method in short) or mono-like directional solidification methods. In a more simple process multi-crystalline silicon ingots are produced by directional solidification (DSS - directional solidification system).

The silicon single crystal has the form of an ingot or a block, mostly with a general cylindrical shape.

In order to obtain wafers, the silicon ingot is squared and sliced into thin wafers having a thickness in the range of 200 $\mu$m or less by a wire sawing / slicing process.

However, such a slicing process produces significant silicon waste which is known as silicon kerf waste.

At present the kerf loss corresponds to about a thickness of 80 $\mu$m, meaning a loss of about 40% per unit length.

Bearing in mind that the photovoltaic industry tends to reduce the wafer thickness even more, the kerf losses might become even higher, unless the diameter of the cutting wire is reduced concurrently. The lower limit for wafer thickness is expected to be around 100 $\mu$m and the lower limit for cutting wire is expected to be around 50 $\mu$m.

Due to its needed high purity, the silicon raw material for ingot manufacturing is cost and energy intensive. Thus, the significant kerf losses, which are presently discarded, present an important economic problem to be solved.

First attempts have proposed to recycle the kerf waste. But recycling is difficult as kerf waste does not only contain silicon, but also, depending on the saw used and the sawing process, metallic particles, carbon and organic compounds from the used coolant or cutting fluid. Such impurities, if not properly eliminated result in recycled silicon feedstock and subsequently Si wafers of low quality or even unusable wafers in particular for photovoltaic applications.

WO2012/109459 relates to a method for recovering silicon value from silicon kerf waste and discusses also other methods to recover kerf waste.

One of the main problems for recycling kerf particles is to manage the separation or filtering of sub-micron particles as the sawing process generally produces a lot of these particles.

US 2014/0144846 relates also to a method for recycling silicon kerf waste and in particular to filter small size particles. However, the inventors have noticed that the application of the teaching of US 2014/0144846 does not produce the desired results on present kerf wastes that have been tested with traditional filtering techniques. Chemical conditioning with commonly used coagulants resulted in flocs between 0.5 and 15 $\mu$m. which were mechanically not stable as proven by a short ultra-sound treatment. Further stabilization by increasing the coagulant concentration is not a viable route due to the increased contamination of the silicon kerf and cutting fluid. An additional observation is that the present Si kerf contains ultrafine particles that are not removable by standard filtration and pass into the recycled cutting fluid, hence reducing the number of reuses and rendering the liquid unusable.

Furthermore, as the volume of cooling liquid used in the wafer sawing process may be relatively large, it could be of great interest for economic and environmental reasons to reduce the amount of used cooling liquid / cutting fluid.

The present invention aims therefore at improving the recovery of the cooling liquid used in the wafer production process in order to reduce both the amount of wasted silicon kerf particles and the amount of used cooling liquid.

The present invention also proposes a method to recycle more efficiently kerf losses when the kerf results from diamond fixed abrasion process like for example diamond wire sawing of single or multi-crystalline silicon ingots.

To this extent, the present invention proposes a method for processing a coolant liquid, herein called suspension, retrieved from a cutting step of silicon ingots to produce wafers, the cutting step being based on a diamond fixed abrasion process, the said suspension being an aqueous solution comprising silicon kerf particles and additives such as surfactants, lubricants, anti-foaming agents, the additives having a concentration below 5% in volume, the method comprising steps for separating at least partially the silicon particles and the liquid part of the suspension, the said steps comprising:

- an agglomeration step, without adding a flocculent or a coagulant, wherein the suspension is aged and stored in a container for a predetermined time longer than 10 minutes to enable agglomeration of remaining kerf particles to form clusters of kerf particles,
- a centrifugation step to produce a centrifugation cake or high-viscosity suspension comprising the clusters of kerf particles and a centrate comprising the liquid part of the suspension wherein the centrate has a concentration of kerf particles lower than 10g/L, preferably lower than 1g/L.

Thanks to the method according to the invention submicron Si-particles, in particular of less than 500nm in volume-based diameter can be recycled more efficiently and can contribute to cost reduction in Si wafer production. In our process we define sub-micron particles as particles having a volume of less than the one of a sphere with 1 $\mu$m diameter. The volume-based particle diameter is given as $D = 2\sqrt[3]{\dfrac{3V}{4\pi}}$, with D being the volume-based diameter and V being the true volume of the particle. For a sub-micron particle, D is smaller than 1 $\mu$m (micron).

The method according to the invention may comprise one or several of the following features taken alone or in combination:
According to an aspect, the agglomeration step comprises the addition of an acid in the suspension to set the pH of the suspension around the point of zero charge of the kerf particles, for example between 6 and 7 and wherein the predetermined time is comprised between 10 and 40 minutes.

According to a further aspect, the acid used during the agglomeration step is acetic acid, hydrochloric acid or carbonic acid.

According to another aspect, the predetermined time of the agglomeration step lasts between 1 and 24 hours in order to produce a change of pH of the suspension due to the oxidation of the silicon particles.

According to an additional aspect, the suspension is set, during the agglomeration step, at a temperature comprised between 0°C and the cloud point of surfactants of the said suspension, for example 30°C.

According to another aspect, the suspension is stirred during the agglomeration step in order to avoid sedimentation of the kerf particles before centrifugation.

According to an aspect, the method also comprises before the agglomeration step:

- a pre-filtration step using filters having a mesh with apertures comprised in a range between 1 and 20 microns, in particular between 1 and 3 microns, in order to filter out debris and contaminants such as diamonds, broken diamond wire, or chipped silicon wafer pieces.

According to another aspect, the method also comprises after the centrifugation step:

- a cross-filtration step of the centrate comprising the liquid part of the suspension with a membrane having a cut off below 500 nm, preferably less than 200 nm.

According to a further aspect, the method may comprise, after the cross-filtration step, an additional optional step of ultra-centrifugation of the cross-filtration retentate.

According to an additional aspect, the coolant liquid obtained and directly retrieved from the cutting step comprises particles having a volume-based diameter smaller than 1 micron and a solid loading up to 5% in weight.

According to an aspect, the cross-filtration permeate retrieved after the cross-filtration step is reused as a coolant liquid of a cutting step of silicon material.

According to another aspect, after the cross-filtration step, the cross-filtration permeate is re-conditioned by the addition of a neutralizing agent or base such as ammonia or sodium hydroxide to increase the pH value.

According to a further aspect, the method comprises after the centrifugation step, a step of drying the centrifugation cake or high viscosity suspension.

According to another aspect, the method comprises, after the step of drying the centrifugation cake or high-viscosity suspension, a step of shaping into a layer the dried centrifugation cake or dried high-viscosity suspension.

According to an additional aspect, the method comprises a step of applying a zone melting step to the said dried centrifugation cake or dried high-viscosity suspension on a substrate to produce a silicon sheet.

The obtained silicon sheet may be broken down into silicon chips or beads.

According to a further aspect, the zone melting step is applied several times in order to produce silicon chips having a predetermined purity.

According to another aspect, between two zone melting steps the obtained chips or beads may be etched chemically or treated mechanically in order to remove impurities that accumulated at the surface of the chips.

According to an additional aspect, after a first zone melting step, the obtained silicon sheet, chips or beads may be re-molten in an electro-magnetic casting process (EMC) to produce a round or square ingot.

According to a further aspect, after a first zone melting step, the obtained silicon sheet, chips or beads may be re-molten in a directional solidification process (DS) to produce square silicon ingots.

According to another aspect, after a first zone melting step, the obtained silicon sheet, chips or beads may be processed by melt refining wherein the silicon is dissolved in molten aluminum and precipitated by lowering the temperature and solubility of silicon in molten aluminum.

According to an additional aspect, after a first zone melting step, the silicon material may be converted into metallurgical grade silicon (MG Si) feedstock by simple crushing or milling of the silicon sheet.

According to an additional aspect, the silicon chips having a predetermined purity after the zone melting step can be used directly as feedstock in the silicon ingot production.

According to a further aspect, the filtered and/or centrifugated kerf particles are retrieved to be recycled as silicon feedstock for wafer production, the recycling being achieved based, after the at least one zone melting step, on a silicon crystal growth method such as floating zone melting method, a Czochralski method or a mono-like directional solidification method or directional solidification.

According to an additional aspect, the centrifugation step is a screw centrifugation step.

The step of centrifugation is for example carried out with a solid bowl decanter centrifuge.

The remaining moisture of the paste of sub-micron Si particles is for example below 70%, in particular between 45% - 55%, and more specifically 50%.

The drying step may be carried out under an inert atmosphere, in particular argon or nitrogen.

According to a further aspect, the drying step is carried out under at a temperature comprised between 350°C and 450°C, in particular between 390°C and 410°C, like for example 400°C.

The drying step may be preceded by a de-oxidation treatment, in particular with hydrofluoric acid.

The paste of sub-micron Si particles is for example compacted prior to said zone melting step.

The compacting step comprises in particular pressing or extrusion of said paste of sub-micron Si particles to obtain thin plates.

The zone melting step may be carried out under an inert atmosphere, in particular argon.

According to a further aspect, the zone melting step is configured to leave a sub-layer of unmolten Si-particles.

The melting depth during the zone melting step is configured to be for example superior to 1mm, in particular comprised between 10-20mm.

The submicron Si-particles resulting from a diamond fixed abrasive process have in particular a volume-based diameter below 500nm, in particular a volume based diameter comprised between 200nm and 400nm.

After the zone melting step, the molten sub-micron Si- particles are for example cooled from one side for solidification in form of a sheet.

After the zone melting step, the solidified silicon sheet may be recovered and broken down in silicon chips.

The silicon chips can be etched chemically or treated mechanically to remove impurities.

The invention also relates to the use of silicon chips produced as described above as a feedstock for a Cz-pulling process for silicon single crystal manufacturing, for the production of multi-crystalline or mono-like silicon ingots.

The present invention also refers to a manufacturing method for producing wafers made from silicon ingots comprising:

- a cutting step based on a diamond fixed abrasion process for sawing a raw silicon material into a plurality of wafers, the said cutting step comprising the use of a coolant liquid which is an aqueous solution comprising kerf particles and additives such as surfactants, lubricants, anti-foaming agents, the additives having a concentration below 5% in volume, wherein the manufacturing method also comprises the method for processing the coolant liquid as described previously.

The present invention also refers to a silicon wafer production facility comprising:

- a sawing station where silicon single crystal ingots are sawn into wafers by a, diamond fixed abrasion process using a coolant liquid, the said coolant liquid being an aqueous solution comprising kerf particles and additives such as surfactants, lubricants, anti-foaming agents, the additives having a concentration below 5% in volume,

  - a coolant liquid processing station comprising:
  - a pre-filtering zone comprising filters having a mesh with apertures comprised in a range between 1 and 20 microns, in particular 1 to 3 microns,
  - a storage container configured for storing the pre-filtered liquid or suspension during a predetermined time longer than 10 minutes to enable agglomeration of kerf particles to form clusters of kerf particles, the storage container may comprise an acid distribution device configured for adding acid to the prefiltered liquid or suspension to set its pH value around the point of zero charge of the kerf particles,
  - a centrifuge configured for producing a centrifugation cake and a centrate having a concentration of kerf particles lower than 10g/L, preferably lower than 1g/L, from the stored prefiltered liquid.

According to an aspect, the silicon wafer production facility also comprises:

- a filtering zone configured for receiving and filtering the centrate at the output of the centrifuge, the said filtering zone having a membrane with a cut off below 500 nm.

BRIEF DESCRIPTIONS OF THE DRAWINGS

Other advantages and characteristics will appear with the reading of the description of the following drawings:

- Figure 1 is a simplified flowchart of the method according to the invention,

- Figure 2 is a simplified view in cross section to illustrate one step of the method according to the invention,
- Figure 3 is a simplified view in cross section to illustrate another step of the method according to the invention,
- Figure 4 is a simplified view in perspective to illustrate the zone melting step,
- Figure 5 is a simplified view in cross section to illustrate the zone melting step according to a first embodiment,
- Figure 6 is a simplified view in cross section to illustrate the zone melting step according to a second embodiment, and
- Figure 7 shows an example of silicon chips produced through the method according to the invention.

DETAILED DESCRIPTION

The embodiment(s) in the following description are only to be considered as examples. Although the description refers to one or several embodiments, this does not mean inevitably that every reference concerns the same embodiment, or that the characteristics apply only to a single embodiment. Simple characteristics of various embodiments can be also combined to new embodiments that are not explicitly described.

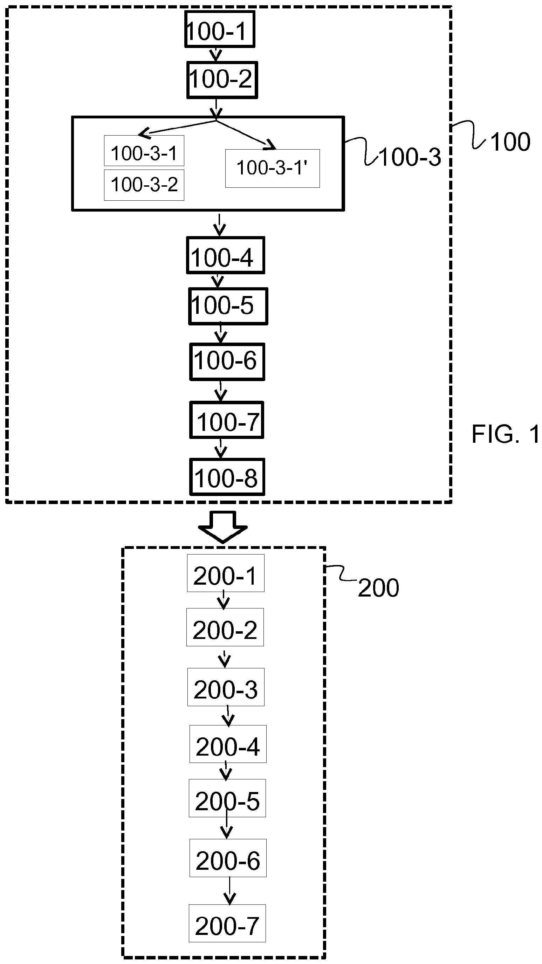

Figure 1 shows a simplified flowchart of the method for processing a coolant liquid resulting from a diamond fixed abrasive cutting process and for recycling sub-micron Si- particles from a Si wafer production process.

The steps in the flowchart of figure 1 may be composed of sub-steps. In addition, some steps or sub-steps are optional and may be combined in another chronological order.

The method according to the invention applies to sub-micron Si-particles from a Si wafer production process resulting from a diamond fixed abrasive cutting process.

By sub-micron Si-particles, it is understood Si-particles having a volume-based diameter of less than $1\mu m$, in particular with a volume based diameter inferior to 500nm, and more precisely comprised between 200nm-400nm.

These very small particles are quite difficult to recycle because of their small size. If a filter of very small size is used, clogging problems impede filtering the small size Si-particles.

The fact that the Si-particles result from a Si wafer production process resulting from a diamond fixed abrasive cutting process means for example that they result from a diamond wire sawing process which is carried out in order to obtain wafers from a silicon single-crystal or multi-crystalline material.

These particles may be contained in the suspension (cutting fluid) of the sawing process, such suspension is also known as Si-kerf suspension. This suspension refers to a coolant liquid that is used during the sawing process and retrieved after the sawing step. The suspension or coolant liquid is a water based solution or aqueous solution. This suspension is usually neutral (pH=7) or slightly basic (pH>7) notably for safety reasons as well as to prevent corrosion of the equipment and to enhance the dispersion of the silicon kerf.

The particularity of Si-kerf suspension resulting from a diamond fixed abrasive cutting process is that the solid content is mainly constituted by sub-micron Si-particles as described above.

The main contaminates of the Si-kerf suspension are:

- (I) metallic impurities such as nickel originating from the cutting wire itself,
- (II) cutting additives from the water based cutting fluid ,
- (III) diamonds broken off the wire during sawing.
- (IV) material from the beam or holder to which the ingot / squared silicon block is attached during the slicing operation

The silicon particles of the Si-kerf suspension are also oxidized on their surface because a thin silicon oxide layer is formed on the particle surfaces due to the presence of water and oxygen.

According to the invention, the Si-kerf suspension is processed in order for the sub-micron Si-particles to be recycled in a way that they can be used, for example, as silicon feedstock in a floating zone melting method or a Czochralski (CZ) pulling process of Si single crystal ingots or a mono-like directional solidification method to produce Si single crystal ingots or alternatively for production of multi-crystalline / mono-like silicon ingots. The recycled silicon feedstock may be mixed with other silicon feedstock such as polysilicon from the Siemens process.

In the present example, sub-micron Si-particles from diamond sawing are used, but also other processes in the Si wafer production process like polishing may give raise to sub-micron Si-particles that may be recycled.

By "diamond fixed abrasive process", it is understood that the diamonds are fixed to the process tool, like for example the steel cutting wire. In other words, abrasive processes using a bulk material like a powder with diamonds are not included.

After diamond wire sawing, the silicon particles are dispersed in the cutting fluid that is water based and contains less than 5 percent of additives in volume, for example about 2 volume percent of additives. The typical solid loading is between 2-5 weight percent. The Si-particles are of sub-micron size as described above. No SiC particles are present in the suspension from diamond sawing. The additives comprise mainly surfactants, lubricants and anti-foaming agents.

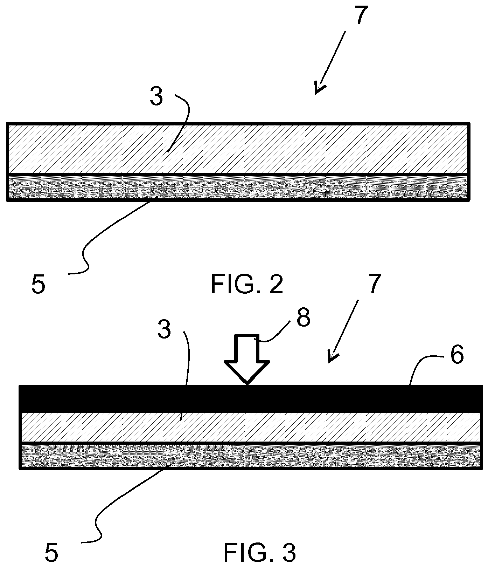

According to a first stage 100, the suspension retrieved after diamond wire sawing is processed in order to separate at least partially the silicon particles, notably the sub-microns particles, and the liquid part of the suspension so that the concentration of remaining Si-particles in the liquid part is a low as possible. Such separation may lead to the provision of a paste 3 of Si particles (see figure 2) resulting from said diamond fixed abrasive process. The first stage 100 comprises several steps.

The first step 100-1 refers to the recovering of Si-kerf suspension from a diamond sawed slicing process wherein a silicon ingot is cut into silicon wafers by a diamond wire using a coolant fluid. The said coolant liquid added to the cutting wastes and notably sub-microns Si kerf particles is then retrieved in step 100-1.

The stage 100 may also comprise a second optional step 100-2 of pre-filtration using filters having a mesh with apertures comprised in a range between 1 and 20 microns, preferably between 1 and 3 microns, in order to filter out large particles remaining in the suspension. Large particles refer to particles larger than the size of the apertures of the mesh used in the pre-filtration step. This prefiltration step 100-2 enables separating on one side pre-filtered large Si-particles and other types of large particles such as debris or contaminants (e.g., diamond, broken diamond wire) and on the other side a pre-filtered liquid or pre-filtered suspension comprising small-size kerf particles. Small-size particles refer to particles smaller than the size of the apertures of the mesh used in the pre-filtration step 100-2. The prefiltered large Si-particles may be sorted and separated from the other large particles to be recycled as silicon ingots (for example based on a process used for the small-size particles describes in the following of the description). In practice such separation may be hard to achieve so that the large particles retrieved in the pre-filtration step may be wasted.

Stage 100 also comprises a third step 100-3 corresponding to an agglomeration step wherein the Si-kerf suspension (coolant liquid) which can be previously pre-filtered or not is stored in a container during a predetermined time without adding any flocculent or coagulant.

According to a first embodiment, this third step 100-3 comprises a first sub-step 100-3-1 wherein the pH value of the Si-kerf suspension is set around the point of zero charge of the kerf particles. This point of zero charge corresponds for example to a pH value between 6 and 7, notably 6,5. Such pH value is obtained by the addition of acid such as carbonic acid, acetic acid or hydrochloric acid.

The second sub-step 100-3-2 is the storing of the Si-kerf suspension with added acid in a container for a predetermined time comprised in a range from 10 to 40 minutes for enabling agglomeration of the sub-micron kerf particles to form clusters of kerf particles having a volume-based diameter larger than one micron.

Furthermore, the Si-kerf suspension can be set at a temperature comprised between 0°C and the cloud point of surfactants of the said Si-kerf suspension, for example 30°C during the storage sub-step 100-3-2.

According to a second embodiment, the third step 100-3 may comprise a sub-step 100-3-1' wherein the Si-kerf suspension is stored for a predetermined time comprised between 1 and 24 hours (without addition of acid). Indeed, the storing in a container of the suspension during a time long enough may lead to a switching of the pH value due to the oxidation of the silicon particles. The pH value may become close to the point of zero charge of the kerf particles, for example between 6 and 7. Consequently, such pH value switching may lead to the formation of clusters of kerf particles having a diameter larger than one micron. Furthermore, the Si-kerf suspension can be set at a temperature comprised between 0°C and the cloud point of surfactants of the said Si-kerf suspension, for example 30°C during the storage step 100-3-1'.

In both embodiments, due to the control of the pH value and possibly the temperature of the Si-kerf suspension, conditions are created to accelerate the formation of clusters of kerf particles due to the respective attraction of the particles for each other due in particular to the Van der Waals forces, capillary forces and electrostatic forces.

Moreover, a stirring of the Si-kerf suspension may also be achieved during this agglomeration step 100-3-2 (or 100-3-1') in order to avoid a sedimentation of the kerf particles (before the centrifugation step 100-4).

The fourth step 100-4 comprises the centrifugation of the Si-kerf suspension to produce a centrifugation cake (or high viscosity suspension) comprising the clusters of kerf particles and a centrate comprising mostly the liquid part of the suspension. The centrate has a concentration of kerf particles which is lower than 10g/L, preferably lower than 1g/L. Such concentration is obtained by the combination of the agglomeration step 100-3 and the centrifugation step 100-4.

The step 100-4 of centrifugation is for example carried out with a solid bowl decanter centrifuge (not shown) also known as screw decanter. Such centrifuges are known to allow efficient separation of liquid and solids. Furthermore, such centrifugation appears to reduce the number of clusters that are broken into several parts during the separation of liquids and solids with respect to filtering methods using mesh filters. The amount of filtered Si-kerf particles that can be recycled is therefore increased.

A solid bowl decanter centrifuge has a continuous unit comprising a bowl with a cylindrical section for efficient separation and clarification of the suspension and a conical section for efficient dewatering of the separated solids, a conveyor (screw) and a gear unit that provides the differential speed between the bowl and the conveyor. An example of such a solid bowl decanter centrifuge is described in EP0199929 and commercialized by Flottweg (registered trademark). The obtained centrifugation cake may then be recycled by applying a zone melting step followed by a floating zone melting method, a Czochralski method or a mono-like directional solidification method as disclosed in the following steps of the method.

Two additional optional steps 100-5 and 100-6 referring respectively to a cross-filtration step and an ultra-centrifugation step may also be applied.

The cross-filtration step 100-5 refers to a filtration of the centrate retrieved from the centrifugation step 100-4 with a membrane having a cut off below 500 nm. The membrane is for example realized with a ceramic tube comprising aluminum oxide ($Al_2O_3$). This fifth step 100-5 leads to a membrane permeate comprising mainly the liquid part of the centrate and a membrane retentate comprising the particles having a size (diameter) larger than the size of the cut-off of the filter used in the fifth step 100-5. The membrane permeate may be reused as a coolant liquid of a sawing step of silicon material. In such case, the membrane permeate may be reconditioned by the addition of ammonia or sodium hydroxide to increase the pH value to a value corresponding to the initial value of the coolant liquid, for example a pH value of 7,5. The kerf particles retrieved in the membrane retentate may be recycled by applying a zone melting step followed by a floating zone melting method, a Czochralski method or a mono-like directional solidification method as disclosed in the following steps of the process.

The sixth step 100-6 refers to an ultra-centrifugation step of the membrane retentate in a centrifuge for filtering the membrane retentate retrieved in the fifth step 100-5. The ultra-centrifugated liquid may then be reused as a coolant liquid of a sawing step of silicon material. In such case, the ultra-centrifugated liquid may be re-conditioned by the addition of ammonia or sodium hydroxide to increase the pH value to a value corresponding to the initial value of the cooling liquid, for example a pH value of 7,5. Alternatively, the ultra-centrifugated liquid may be recirculated in the membrane of the cross-filtration step 100-5. The kerf particles retrieved in the ultra-centrifugation cake may be recycled by applying a zone melting step followed by a floating zone melting method, a Czochralski method or a mono-like directional solidification method as disclosed in the following steps of the process.

Thus, the step 100-4 and possibly the steps 100-5 and 100-6 enables performing an improved filtration or separation wherein a high part of the sub-micron particles of the suspension retrieved after the sawing step can be separated from the liquid part without using flocculents or coagulants so that the retrieved liquid part can be reused in the wafer manufacturing process as a coolant liquid as described in the following of the description (no contamination of the liquid by coagulants or flocculents).

The seventh step 100-7 comprises the fact of drying the centrifugation cake retrieved from the fourth step 100-4 and/or the sixth step 100-6 in order to recycle the filtered large Si particles. Large particles retrieved in the step 100-2 may also be used in this step and the following steps.

The retrieved centrifugation cake may correspond to a paste 3 of Si particles with a remaining moisture of the paste of sub-micron Si particles is for example below 70%, in particular between 45% - 55%, and more specifically 50%.

The drying step 100-7 provides a silicon powder which can be used in a polysilicon or silicon wafer production technique known in the state of the art or can be used in a zone melting method as described in the following steps of the description. The dried silicon powder may also be used in other applications, for example as alloying element for aluminum.

The obtained centrifugation cake or silicon paste may be applied on a substrate 5 which has the function of a mechanical support in a step 100-8 (with or without a previous drying). This is shown on figure 2 in a simplified way.

The substrate 5 should be realized in a material that will not interact with the Si-particle or silicon. In addition, it should maintain its shape even if it is subject to high temperature gradients. The substrate 5 may be rigid or flexible. In the latter case, it may be realized as a conveyor belt for example. The substrate 5 may be made of graphite, silicon carbide, silica or alumina for example. A coating to prevent interaction of the silicon with the substrate 5 may be foreseen.

The second stage 200 refers to the recycling of the centrifugation cake or silicon paste (or silicon powder) obtained in step 100-2, 100-4 or 100-6 (or 100-7), the paste 3 of Si-particles is shaped into a layer 7 like shown in a simplified way in figure 2.

In step 200-1, the paste 3 is shaped, meaning for example applied to the substrate 5 to form a layer 7 of a certain thickness of at least 10mm, but preferentially between 20-25mm.

Optionally, a de-oxidation treatment, in particular with hydrofluoric acid may be carried out in a step 200-2.

Then in step 200-3, the layer 7 is further dried for example in an oven under an inert atmosphere, in particular argon or nitrogen, and at a temperature comprised between 350°C and 450°C, in particular between 390°C and 410°C, like for example 400°C.

Optionally, in a step 200-4, the dried and shaped layer 7 is then compacted, as can be seen in figure 3, in particular by pressing a plate 6 (see arrow 8) or extrusion of said paste 3 of Si particles to obtain for example thin plates.

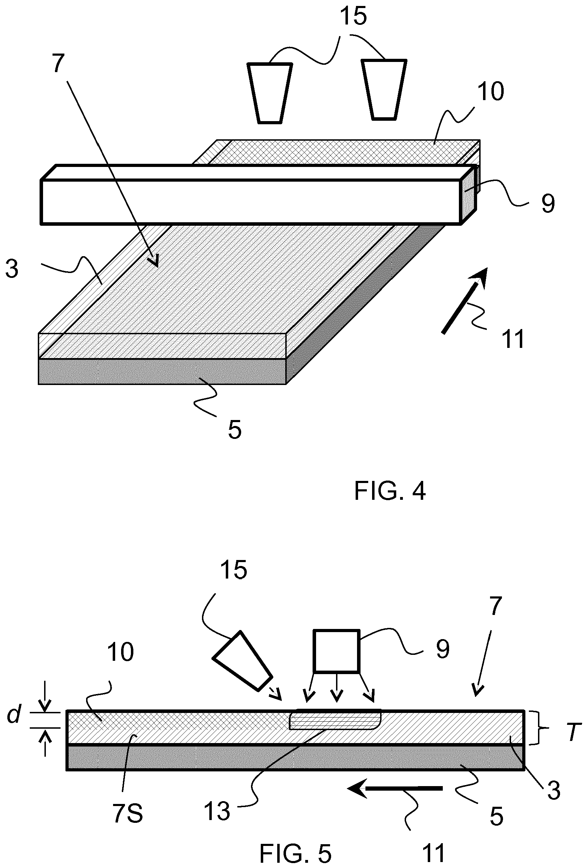

As shown in figures 4, 5 and 6, a zone melting step 200-5 is applied to said dried and shaped layer 7 of Si particles on said substrate 5. This zone melting step 200-5 is carried out under an inert atmosphere, in particular argon.

In zone melting the dried and shaped layer 7, Si particles are molten in a narrow region and give raise to solidification of the silicon particles to form a solidified sheet of silicon 10.

Zone melting has the advantage to have a high surface to volume ratio allowing therefore for effective heat transfer and melting.

To this extent, for example a strip heater element 9 disposed in front of the substrate 5 carrying the dried and shaped layer 7 of Si particles and the substrate 5 is for example moved according arrow 11 with respect to the strip heater element 9. The moving speed of the substrate 5 with respect to the strip heater element can range from 10-1000mm/min.

The strip heater element 9 may comprise a halogen emitter with an optical concentrator directing the generated heat towards the dried and shaped layer 7 of Si-particles. The strip heater may also be a SiC or graphite filament / rod / narrow serpentine heater.

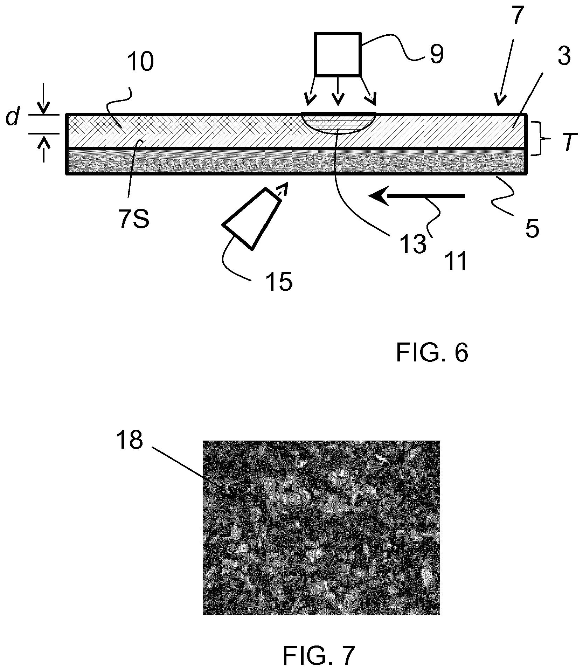

As seen in figures 5 and 6, beneath the strip heater element 9 is established a well localized melting zone 13.

In function of several parameters, in particular the shape of the emitted heat radiation, the moving speed of the substrate 7 with respect to the strip heater element 9 and, as will be explained later on, well positioned cooling devices (like gas jets 15, or heat sinks - the molten silicon in the melting zone 13 may be cooled from one side, top side or bottom side), the form, extent end depth $d$ of the melting zone 13 can be controlled.

The creation of a well-defined temperature profile allows controlling closely melting and especially solidification.

The melting depth $d$ during the zone melting step is configured to be above 1mm, in particular about 10-20mm, but less than the overall thickness $T$ of the layer 7.

Indeed, the zone melting step 200-5 is configured to leave a sub-layer 7S of unmolten Si-particles, for example with a thickness $(T-d)$ superior to 0.1mm, in particular 1-2mm. This facilitates the separation of the solidified silicon from the substrate 5, once the solidified silicon has cooled down.

The temperature profile governs the heat flow and consequently the shape of the liquid solid interface, the direction of the solidification of the molten silicon, and nucleation that defines the microstructure and grain size.

In figure 5, cooling gas jets 15 are positioned on the top face. In this case, heat is mainly extracted from the top and solidification can start on the top of the melt surface and progresses towards the non-molten part of layer 7 in direction to the substrate 5. Instead of a cooling gas another heat sink or heat extraction device may be used.

In this case, impurities will be transported by segregation to the bottom of the silicon sheet 10 that is formed through solidification after the melting zone 13. After cooling down, the solidified Si - sheet 10 is enriched with impurities at its boundaries which can be removed chemically, e.g. by etching, or treated mechanically. The remaining silicon sheet 10 has lower impurity content than the original paste 3 of Si-particles and can be further processed, e.g. broken into chips or granules.

In figure 6, heat sink or cooling gas jets 15 are positioned on the bottom face. In this case, heat is extracted mainly from the bottom and solidification can start on the bottom of the melt at the interface to the non-molten silicon particles. This will result in columnar grain growth because nucleation will be caused by the non-molten powder layer. Silicon melt that solidifies last can be trapped between individual grains and be expelled to the silicon surface as small beads or droplets. This silicon material has a high concentration of impurities and can be subsequently removed mechanically, e.g. sieving, or by other methods.

The control of the temperature profile also allows controlling of the temperature gradient at the solid liquid interface. A sharp temperature gradient can prevent dendritic growth during crystallization of the molten silicon by avoiding an undercooled silicon melt. This is beneficial for the segregation of impurities during the solidification.

Another aspect of controlling the temperature profile is the ability to tailor the microstructure and grain size of the solidified silicon. If the silicon material is broken afterwards the grain size directly correlates with the obtained particle size. The regions between the grains can be enriched with impurities. These impurities can be removed by washing of the particles and simultaneously etching, e.g. with nitric / hydrofluoric acid as commonly done in industry. Thus, controlling the microstructure during solidification allows governing the impurity distribution in the solidified silicon.

In zone melting, the silicon particles forming a sheet can be cooled down rapidly below a temperature at which back diffusion of impurities does not occur anymore. It is noteworthy that this cannot be achieved in crucibles based segregation methods that are commonly used in industry.

As oxygen can evaporate during the melting as well, the zone melting step 200-5 does not only consolidate the Si-particles but also represents a first cleaning step.

After the zone melting step, the solidified silicon is recovered and broken down in chips 18 in a step 200-6 (see also figure 7).

As stated above, these silicon chips 18 may be etched chemically or treated mechanically in a step 200-7 in order to remove impurities that accumulated at the surface of the chips.

These silicon chips 18 are now of high added value and are considered as solar grade silicon as they can be used directly as feedstock in particular for a CZ-pulling process or production of multi-crystalline or mono-like silicon ingots. Indeed, the benefit of the obtained silicon sheet, chips or beads is that it has a high fill factor and can be more effectively molten in a crucible.

Depending on the individual composition of paste of Si-particles resulting from said diamond fixed abrasive process, a further refining or segregation step corresponding for example to an additional zone melting step may be necessary in order to remove metallic impurities if the silicon purity does not match a predetermined purity level. This further refining or segregation step may take place after one of the steps 200-5, 200-6 or in particular 200-7 as described above.

Dopants such as boron or phosphorous are present in sufficient low concentration in the recovered silicon after the zone melting step 200-5.

Several possibilities for refining or segregation are available, like the following that are mentioned as non-limiting examples:

1) The silicon sheet, chips or beads obtained by zone melting step 200-5 may be re-molten in performing the zone melting step 200-5 twice, directly after the first zone melting step 200-5, but preferably after having etched chemically or treated mechanically in step 200-7 the chips 18 in order to remove impurities that accumulated at the surface of the chips.

2) The silicon sheet, chips or beads obtained by zone melting step 200-5 may be re-molten in an electromagnetic casting process (EMC) to produce a round or square ingot. From this ingot solar grade silicon can be obtained.

3) The silicon sheet, chips or beads obtained by zone melting step 200-5 may be re-molten in a directional solidification process (DS) to produce square silicon ingots.

4) The silicon sheet, chips or beads obtained by zone melting step 200-5 step may be processed by melt refining. In this process the silicon is dissolved in molten aluminum and precipitated by lowering the temperature and solubility of silicon in molten aluminum. Such a process is disclosed in patent US8562932 B2.

5) After zone melting step 200-5, the silicon material may be converted into metallurgical grade silicon (MG Si) feedstock by simple crushing or milling the silicon sheet. This material could be reintroduced into the fluidized bed reactor (FBR) hydrochlorination of the standard Siemens process.

Thus, the method as disclosed above allows quite efficiently recycling of sub-micron Si-particles from a Si wafer production process resulting from a diamond fixed abrasive process, in particular slicing and cutting and to get rid of the difficulties to melt a powder of submicron silicon particles due to its low thermal conductivity and the presence of silicon oxide on the particle surface.

The present invention also refers to a manufacturing method for producing wafers made from silicon ingots comprising:

- a cutting step based on a diamond fixed abrasion process for sawing a raw silicon material into a plurality of wafers, the said cutting step comprising the use of a coolant liquid which is an aqueous solution comprising kerf particles and additives such as surfactants, lubricants, anti-foaming agents, the additives having a concentration below 5% in volume.

The cutting step may be performed in a sawing station.

The manufacturing method also comprises the processing of the retrieved coolant liquid or suspension as described previously in order to recycle the Si-kerf particles of the suspension and possibly to recycle the liquid part of the suspension to be reused as a coolant liquid in a cutting step.

The processing of the suspension may be achieved in a coolant liquid processing station. Said coolant liquid station comprises for example:

- a pre-filtering zone comprising filters having a mesh with apertures comprised in a range between 1 and 20 microns,
- a storage container configured for storing the prefiltered liquid during a predetermined time longer than 10 minutes to enable agglomeration of kerf particles to form clusters of kerf particles, the storage container may comprise an acid distribution device configured for adding acid to the prefiltered liquid to set its pH value around the point of zero charge of the kerf particles,
- a centrifuge configured for producing a centrifugation cake from the stored prefiltered liquid.
- a filtering zone configured for receiving and filtering the centrate at the output of the centrifuge, the said filtering zone having a membrane with a cut off below 500 nm, preferably less than 200nm.

Thus, the present invention enables separation of kerf particles and the liquid part of the coolant liquid used in a wafer sawing process as well as the recycling of the retrieved liquid part as a coolant liquid on one side and the recycling of Si-kerf particles and notably submicron particles. Such separation and recycling being achieved thanks to the application of an agglomeration step to form clusters of sub-micron particles having a size larger than a micron combined with a centrifugation step in order to separate the agglomerates and the liquid part without breaking the bonds formed during the agglomeration step. Such a silicon recycling process enables reducing the amount of wasted Si-particles and such a liquid recycling process enables reducing the required amount of water used for ingot and wafer cutting. These recycling methods lead therefore to a reduction of the overall production costs for silicon wafers and tend to reduce the environmental impact of the wafer production.

**Claims**

1. Method for processing a coolant liquid, herein called suspension, retrieved from a cutting step of silicon ingots to produce wafers, the cutting step being based on a diamond fixed abrasion process, the said suspension being an aqueous solution comprising kerf particles and additives such as surfactants, lubricants, anti-foaming agents, the additives having a concentration below 5% in volume, the method comprising a stage (100) for separating at least partially the silicon particles and the liquid part of the suspension, the said stage (100) comprising:

- an agglomeration step (100-3), without adding a floculant or a coagulant, wherein the suspension is stored in a container for a predetermined time longer than 10 minutes to enable agglomeration of remaining kerf particles to form clusters of kerf particles,
- a centrifugation step (100-4) to produce a centrifugation cake or high-viscosity suspension comprising the clusters of kerf particles and a centrate comprising the liquid part of the suspension wherein the centrate has a concentration of kerf particles lower than 10g/L, preferably lower than 1g/L.

2. Method in accordance with claim 1 wherein the agglomeration step (100-3) comprises the addition of an acid in the suspension to set the pH of the suspension around the point of zero charge of the kerf particles (100-3-2), for example between 6 and 7 and wherein the predetermined time is comprised between 10 and 40 minutes.

3. Method in accordance with claim 2 wherein the acid used during the agglomeration step (100-3) is acetic acid or hydrochloric acid or carbonic acid.

4. Method in accordance with claim 1 wherein the predetermined time of the agglomeration step (100-3) lasts between 1 and 24 hours in order to produce a change of pH of the suspension due to the oxidation of the silicon particles (100-3-1').

5. Method in accordance with one of the previous claims also comprising after the centrifugation step (100-4):

- a cross-filtration step (100-5) of the centrate comprising the liquid part of the suspension with a membrane having a cut off below 500 nm, preferably less than 200nm.

6. Method in accordance with one of the previous claims wherein the suspension is set, during the agglomeration step (100-3), at a temperature comprised between 0°C and the cloud point of surfactants of the said suspension, for example 30°C.

7. Method in accordance with one of the previous claims wherein the suspension is stirred during the agglomeration step (100-3) in order to avoid sedimentation of the kerf particles before centrifugation.

8. Method in accordance with one of the previous claims also comprising before the agglomeration step (100-3):

- a pre-filtration step (100-2) using filters having a mesh with apertures comprised in a range between 1 and 20 microns, in particular between 1 and 3 microns, in order to filter out particles larger than the size of the apertures of the mesh such as debris and contaminants, for example diamonds, broken diamond wire or chipped silicon wafer pieces.

9. Method in accordance with one of the previous claims wherein the coolant liquid obtained and retrieved from the cutting step comprises particles having a volume-based diameter smaller than 1 micron and a solid loading up to 5% in weight.

10. Method in accordance with one of the previous claims in combination with claim 5 wherein the membrane permeate retrieved after the cross-filtration step (100-5) is reused as a coolant liquid of a cutting step of silicon material.

11. Method in accordance with claim 10 wherein, after the cross-filtration step (100-5), the membrane permeate is re-conditioned by the addition of a neutralizing agent or base such as ammonia or sodium hydroxyde to increase the pH value.

12. Method in accordance with one of the previous claim wherein it also comprises after the centrifugation step (100-4):

- a step of drying the centrifugation cake (100-7).

13. Method in accordance with claim 12 wherein it also comprises after the step of drying the centrifugation cake:

- a step of shaping into a layer the dried centrifugation cake (200-1).

14. Method in accordance with one of the previous claims wherein it comprises

- a step of applying a zone melting step (200-5) to the centrifugation cake on a substrate (5).

15. Method in accordance with claim 14 wherein the zone melting step (200-5) is applied several times to obtain the desired purity.

16. Method in accordance with one of the previous claims in combination with claim 14 or 15 wherein the filtered and/or centrifugated kerf particles are retrieved to be recycled as silicon feedstock for wafer production, the recycling being achieved, after at least one zone melting step (105), based on silicon crystal growth method such as floating zone melting method, a Czochralski method, a mono-like directional solidification method or a directional solidification.

17. Method in accordance with claims 16 wherein after the at least one zone melting step, the molten submicron Si- particles are cooled from one side for solidification in form of a sheet, the solidified silicon sheet is recovered and broken down in silicon chips, the silicon chips are etched chemically or treated mechanically to remove impurities and the silicon chips are used as a feedstock for a Cz-pulling process for silicon single crystal manufacturing, for the production of multi-crystalline or mono-like silicon ingots.

18. Method in accordance with one of the previous claims wherein the centrifugation step (100-4) is a screw centrifugation step.

19. Manufacturing method for producing wafers made from silicon ingots comprising:

- a cutting step based on a diamond fixed abrasion process for sawing a raw silicon material into a plurality of wafers, the said cutting step comprising the use of a coolant liquid which is an aqueous solution comprising kerf particles and additives such as surfactants, lubricants, anti-foaming agents, the additives having a concentration below 5% in volume, wherein the manufacturing method also comprises the method for processing the coolant liquid according to one of the previous claims.

20. Silicon wafer production facility comprising:

- a sawing station where silicon single crystal ingots are sawed into wafers by a, diamond fixed abrasion process using a coolant liquid, the said coolant liquid being an aqueous solution comprising kerf particles and additives such as surfactants, lubricants, anti-foaming agents, the additives having a concentration below 5% in volume,

- a coolant liquid processing station comprising:
- a pre-filtering zone comprising filters having a mesh with apertures comprised in a range between 1 and 20 microns, preferably 1 to 3 microns,
- a storage container configured for storing the pre-filtered liquid during a predetermined time longer than 10 minutes to enable agglomeration of kerf particles to form clusters of kerf particles, the storage container comprising an acid distribution device configured for adding acid to the prefiltered liquid to set its pH value around the point of zero charge of the kerf particles,
- a centrifuge configured for producing a centrifugation cake and a centrate having a concentration of kerf particles lower than 10g/L, preferably lower than 1g/L, from the stored prefiltered liquid.

21. Silicon wafer production facility in accordance with claim 20 also comprising:

- a filtering zone configured for receiving and filtering the centrate at the output of the centrifuge, the said filtering zone having a mesh membrane having a cut off below 500 nm, preferably less than 200nm.

FIG. 1

FIG. 2

FIG. 3

15

7

10

9

3

11

5

FIG. 4

15

10

9

7

d

$T$

7S

13

3

5

11

FIG. 5

FIG. 6

FIG. 7

Europäisches
Patentamt

European
Patent Office

Office européen
des brevets

# EUROPEAN SEARCH REPORT

**Application Number**

EP 18 30 5753

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/215561 A1 (LAN C W [TW] ET AL) 26 August 2010 (2010-08-26) | 1-13, 18-21 | INV. C30B29/06 C30B35/00 B28D5/00 C01B33/021 |
| Y | * paragraph [0013] - paragraph [0020]; claims 1-12 * | 14-17 | |
| X | US 8 425 639 B2 (CABOT MICROELETRONICS CORP) 23 April 2013 (2013-04-23) * claims 1-6; figure 1; example 1 * | 1-13, 18-21 | |
| X | CN 102 642 837 B (HENAN XINDAXIN MATERIALS CO LTD) 24 July 2013 (2013-07-24) * claims 1-7; figure 1 * | 1-13, 18-21 | |
| Y | US 2016/348271 A1 (RAVI JAGANNATHAN [US] ET AL) 1 December 2016 (2016-12-01) * claims 1-12; figure 1 * | 14-17 | |
| A | US 2010/170495 A1 (DALITZ LOTHAR [DE] ET AL) 8 July 2010 (2010-07-08) * claims 1-16; figure 2 * | 1-21 | |

**TECHNICAL FIELDS SEARCHED (IPC)**

C30B
B28D
C01B

The present search report has been drawn up for all claims

| Place of search | Date of completion of the search | Examiner |
|---|---|---|
| The Hague | 14 December 2018 | Lavéant, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 584 355 A1**

## ANNEX TO THE EUROPEAN SEARCH REPORT
## ON EUROPEAN PATENT APPLICATION NO.

EP 18 30 5753

14-12-2018

| Patent document cited in search report | | | Publication date | Patent family member(s) | | | Publication date |
|---|---|---|---|---|---|---|---|
| US 2010215561 | A1 | | 26-08-2010 | TW<br>US | 200827305<br>2010215561 | A<br>A1 | 01-07-2008<br>26-08-2010 |
| US 8425639 | B2 | | 23-04-2013 | NONE | | | |
| CN 102642837 | B | | 24-07-2013 | NONE | | | |
| US 2016348271 | A1 | | 01-12-2016 | NONE | | | |
| US 2010170495 | A1 | | 08-07-2010 | CA<br>EP<br>JP<br>JP<br>US<br>WO | 2643553<br>2205387<br>5557391<br>2011502346<br>2010170495<br>2009056153 | A1<br>A1<br>B2<br>A<br>A1<br>A1 | 30-04-2009<br>14-07-2010<br>23-07-2014<br>20-01-2011<br>08-07-2010<br>07-05-2009 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012109459 A
- US 20140144846 A
- EP 0199929 A
- US 8562932 B2